# EUROPEAN PATENT APPLICATION

(11) **EP 1 876 875 A2**
(43) Date of publication of application: **09.01.2008**
(21) Application number: 07012383.1
(22) Date of filing: 25.06.2007
(51) Int. Cl.: H05K 7/18

(54) **Modular rack design**

(30) Priority: 05.07.2006 US 481293
(71) Applicant: Northrop Grumman Corporation, Los Angeles, CA 90067 (US)
(72) Inventor: Tenreiro, Antonio, Palm Bay, Florida 32907 (US); Duerr, Robert A., Merritt Island, Florida 32952 (US); Johnson, David R., Satellite Beach, Florida 32937 (US); Rooks, Ashley, Orlando, Florida 32828 (US)
(74) Representative: Serjeants

(57) **Abstract**

A transportable modular rack system (20) is disclosed. The transportable modular rack system comprises a modular cage (26) and a moveable insert rack (28) that is at least partially positionable within the interior of the modular cage. Articles and/or article housings (30) can be positioned on shelves (130) positioned within the interior of the moveable insert rack (26). The transportable modular rack system (20) is suitable for use in aircraft, watercraft and/or land vehicles. A pallet-mounted transportable modular rack system comprising modular rack components and moveable insert rack components is also disclosed.

## Description

### FIELD OF THE INVENTION

The present invention relates to a transportable rack structure, and more particularly, to a transportable rack structure having a modular cage and a moveable insert rack.

### BACKGROUND INFORMATION

Storage assemblies for supporting and enclosing vertically stacked electronic equipment such as computer components, sound equipment, radar and video equipment are well known. However, traditional storage assemblies are typically configured to remain in a fixed position once individual electronic components are situated within the storage assembly. Accordingly, in traditional storage assemblies, if an individual electronic and/or mechanical component and/or series of components needed to be moved to another location within the storage assembly, each component had to be removed from its original position and reinstalled at another position within the storage assembly. This necessitated additional handling of electronic equipment and increased setup time to reconfigure the storage assembly.

Additionally, traditional storage assemblies typically comprise relatively bulky components such as long vertical support posts and wide horizontal support posts. The physical dimensions of traditional storage assemblies can prohibit their use in confined spaces such as within submarines, on aircraft or within vehicles. In these settings, traditional storage assemblies can be both difficult to transport into, and assemble within, a confined space such as a ship, boat, submarine, aircraft or vehicle.

Accordingly, a need remains for a unique storage assembly that can be transported into and assembled within a confined space that allows electronic components to be moved within the storage assembly while minimizing additional handling of the electronic components.

### SUMMARY OF THE INVENTION

The present invention provides a modular storage assembly that can be removeably mounted on a pallet and transported into a confined area. The modular storage assembly can be assembled within the confined area by removing the pallet-mounted components, constructing the modular cage, constructing the moveable insert rack, and inserting the moveable insert rack at least partially within the modular cage by sliding the insert rack over a retainer bar of the modular cage. Articles and/or article housings can be inserted within the moveable insert rack and secured within the modular cage. Individual moveable insert racks can be removed from a first location within a modular cage network and repositioned at a new location within the modular cage network without removing the articles and/or article housings from the moveable insert rack.

An aspect of the present invention is to provide a transportable modular rack system comprising a modular cage securable to a surface and a moveable insert rack at least partially receivable within the modular cage. The modular cage comprises a first side panel, a second side panel opposite the first side panel, and at least one detachable retainer bar member extending from the first side panel to the second side panel. The moveable insert rack comprises a base, a first and second insert panel detachably mounted on the base, and at least one shelf removeably mounted on and extending between the first and second insert panels.

Another aspect of the present invention is to provide a transportable pallet-mounted modular rack system comprising modular cage components removeably mounted on the pallet and moveable insert rack components removeably mounted on the pallet. The modular cage components comprising a first side and second side panel, and at least one detachable retainer bar member which may be secured between the first side and the second side panels.
The moveable insert rack components comprising a base, a first and second insert panel detachably mountable on the base, and at least one shelf which may be removeably mountable on and extend between the first and second insert panels.

A further aspect of the present invention is to provide a method of assembling a modular rack in a vehicle, comprising the steps of securing a modular cage to the vehicle, assembling a moveable insert rack, and inserting the moveable insert rack at least partially within the modular cage by sliding the moveable insert rack over the retainer bar at least partially into the modular cage.

These and other aspects of the present invention will be more fully understood following a review of this specification and drawings.

### BRIEF DESCRIPTION OF THE DRAWINGS

Figure 1 is a perspective view of the interior of a vehicle and a transportable pallet-mounted modular rack system positioned within a vehicle in accordance with the present invention.

Figure 2 is a perspective view of components of a transportable pallet-mounted modular rack system and a partially assembled modular cage in accordance with the present invention.

Figure 3 is a partial perspective view of a modular cage and a panel support member engaging the first side panel and second side panel in accordance with the present invention.

Figure 4 is a perspective view of components of a transportable pallet-mounted modular rack system and a fully assembled modular cage in accordance with the present invention.

Figure 5 is a perspective view of components of a transportable pallet-mounted modular rack system, a fully assembled modular cage, and a moveable base and a back insert panel engaging the moveable base in accordance with the present invention.

Figure 6 is a perspective view of components of a transportable pallet-mounted modular rack system, a fully assembled modular cage, and a moveable base engaged with a back inset panel and a first and second insert panel in accordance with the present invention.

Figure 7 is a perspective view of components of a transportable pallet-mounted modular rack system, a fully assembled modular cage, a moveable base engaged with a back insert panel, a first and second insert panel, and a plurality of shelves in accordance with the present invention.

Figure 8 is a perspective view of components of a transportable pallet-mounted modular rack system, a fully assembled modular cage, a moveable base engaged with a back insert panel, a first and second insert panel, and a plurality of shelves supporting equipment housing in accordance with the present invention.

Figure 9 is a perspective view of a moveable insert rack partially engaged within a modular outer cage in accordance with the present invention.

Figure 10 is a perspective view of a moveable insert rack partially engaged within a modular cage in accordance with the present invention.

Figure 11 is an enlarged portion of the perspective view of Figure 10.

Figure 12 is a perspective view of a moveable insert rack secured within a modular cage by a plurality ofdetachable bar members in accordance with the present invention.

Figure 13 is a perspective view of multiple modular cages and multiple moveable insert racks in accordance with the present invention.

### DETAILED DESCRIPTION

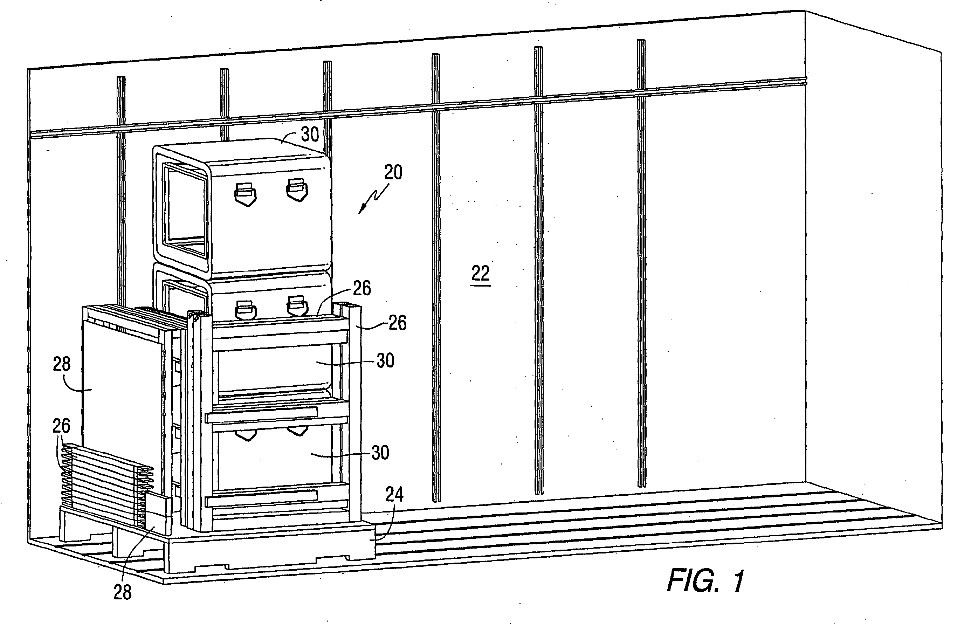

As shown in Figure 1, a transportable pallet-mounted modular rack system 20 is shown within the interior of a confined space, such as the interior of a vehicle 22. As used herein, the term "vehicle" includes aircraft, such as planes and helicopters, and the like, watercraft, such as ships, boats, submarines, and the like, and land vehicles, such as cars, trucks, buses, tanks, and the like. The transportable pallet-mounted modular rack system comprises components that are removeably mounted on a pallet 24. In one embodiment, the pallet 24 can be any commercially available pallet. In another embodiment, the pallet 24 can be specially designed to correspond to the specific dimensions of the transportable modular rack system. The pallet 24 and removeably mounted components can be introduced into the interior of a confined space by a skid or other motorized vehicle, or carried in manually. In one embodiment, all of the components of the modular rack system 20 are removeably mounted on a single pallet.

As shown in Figure 1, the components of the modular rack system 20 comprise modular cage components 26 and moveable insert rack components 28. When assembled, the modular cage components form a modular cage and the moveable insert rack components form moveable insert rack as will be described herein. The modular rack system 20 may also optionally comprise article(s) and/or article housing(s) 30 that can be secured and/or stored within the modular rack system 20 once assembled. As used herein, the term "article" can include electronic components, computers, computer components, sensors, radars, mechanical devices, optical sensors, and the like. As used herein, the term "article housing" can include any suitable storage structure for housing and/or protecting an article, such as a case, packaging, and the like.

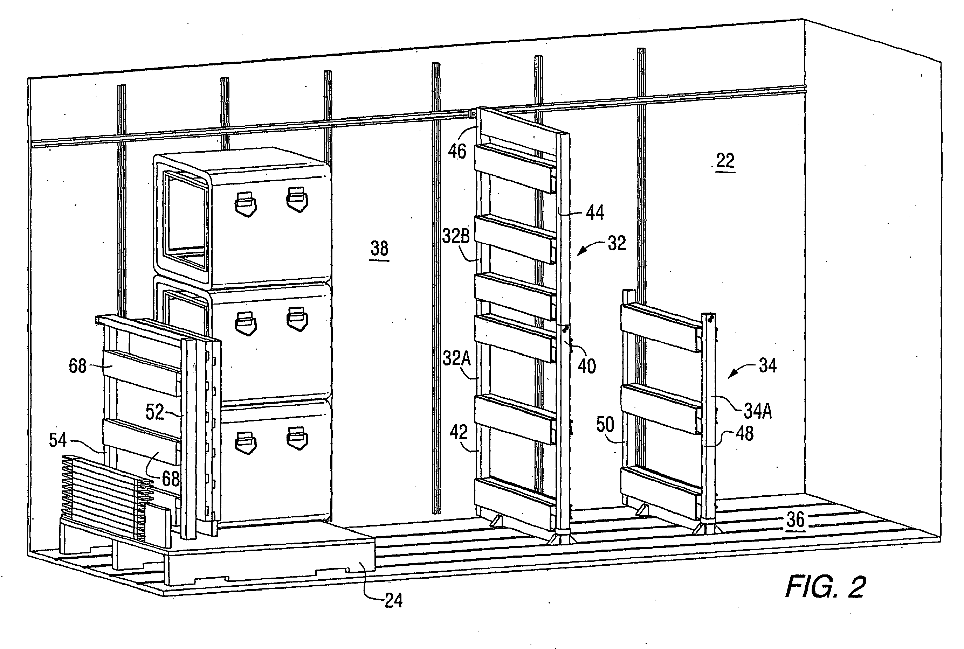

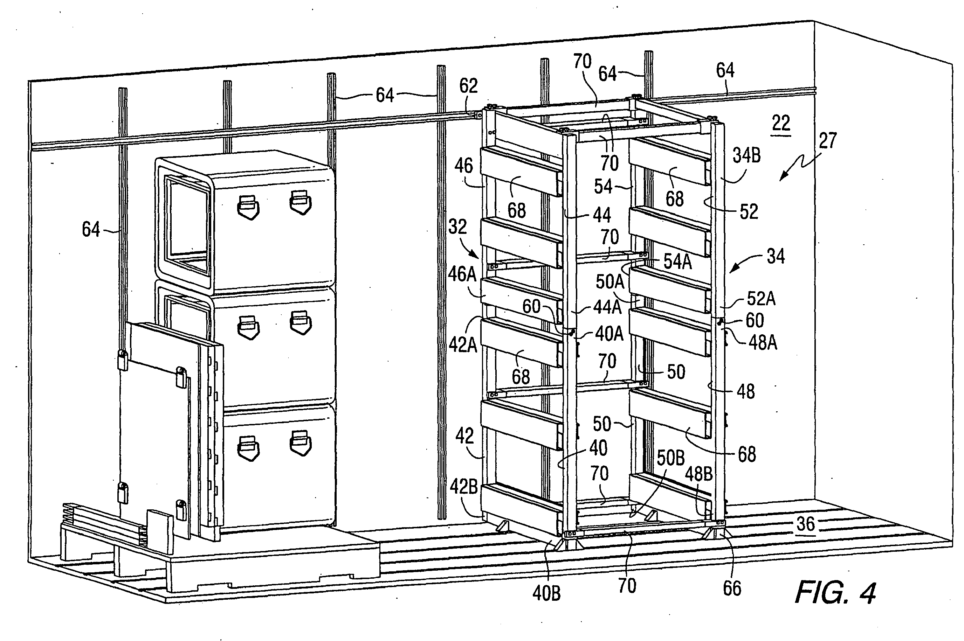

As shown in Figure 2, the modular cage components include a first side panel 32 and a second side panel 34. The first side panel 32 can comprise a first section 32A and a second section 32B. The second side panel 34 can comprise a first section 34A and a second section (shown in the unassembled position in Figure 2 as unassembled posts 52 and 54 connected by panel support member 68, and in Figure 4 in the assembled position as second section 34B). In one embodiment, at least a portion of the first side panel 32 and/or at least a portion of the second side panel 34 is securable to a surface, such as a floor 36, wall 38 and/or ceiling of a vehicle 22. In one embodiment, as shown in Figure 2, the first side panel 32 and the second side panel 34 can be positioned opposite each other and secured to the floor 36. Each of the first side panel 32 and the second side panel 34 can comprise a continuous panel or a plurality of panel sections that can be assembled into a continuous panel. The first side panel 32 can comprise a first section 32A and a second section 32B that is attachable and/or detachable from the first section 32A. The second side panel 34 can comprise a first section 34A and a second section 34B (shown in Figure 4) which is attachable and/or detachable from the first section 34A. The first sections 32A and 34A can be detached from the second section 32B and 34B (shown in Figure 4) when removeably mounted on the pallet 24, and can be attached to each other when assembled within the vehicle 22. As shown in Figure 2, the first panel 32 is fully assembled and the second panel 34 is partially assembled and partially removeably mounted on the pallet 24.

Still referring to Figure 2, the first section 32A of the first side panel 32 can comprise a lower front vertical support post 40 and a lower rear vertical support post 42, and the second section 32B of the first side panel 32 can comprise an upper front vertical support post 44 and an upper rear vertical support post 46. The first section 34A of the second side panel 34, shown in Figure 2 in the assembled position, can comprise a lower front vertical support post 48 and a lower rear vertical support post 50 and the second section of the second side panel, shown in Figure 2 in the pallet-mounted unassembled position, can comprise an upper front vertical support post 52 and an upper rear vertical support post 54. The lower front vertical support post 40 can be engageable with the upper front vertical support post 44 and the lower rear vertical support post 42 can be engageable with the upper rear vertical support post 46. Similarly, the lower front vertical support post 48 can be engageable with the upper front vertical support post 52 and the lower rear vertical support post 50 can be engageable with the upper rear vertical support post 54.

As shown in the fully assembled position in Figure 4, the lower front and rear vertical support posts 40, 42, 48 and 50 can comprise an upper end 40A, 42A, 48A and 50A that is configured to be received within a lower end 44A, 46A, 52A and 54A of the upper front and rear vertical support posts 44, 46, 52 and 54. The upper end 40A, 42A, 48A and 50A can be tapered or have an area of reduced diameter that can be received within the lower end 44A, 46A, 52A and 54A. Likewise, the lower end 44A, 46A, 52A and 54A can be configured to be received within the upper end 40A, 42A, 48A and 50A. In another embodiment, the upper end 40A, 42A, 48A and 50A and the lower end 44A, 46A, 52A and 54A can be engaged by any conventionally known fastening means 60, such as held together by rivets, bolts and nuts, pins, screws, nails and other reuseable fasteners.

As shown in Figure 4, one or more of the first side panel 32 and/or the second side panel 34 can be secured to a surface, such as a floor 36, wall or ceiling of a vehicle interior 22. In one embodiment, the upper rear vertical support post 46 of the first side panel 32 can be secured to a vehicle wall by any suitable fastening means 62. In another embodiment, the upper rear vertical support post 46 can be secured to a securing track 64 which can be installed along a wall surface to allow additional securement of the modular cage to the vehicle interior. In another embodiment, lower front and rear vertical support posts 40, 42, 48 and 50 can comprise a lower end 40B, 42B, 48B and 50B which can be secureable to a surface, such as a vehicle floor 36 by any conventional securing means. In another embodiment, lower front and rear vertical support posts 40, 42, 48 and 50 can comprise at least one foot 66 which is securable to a surface, such as a vehicle floor by any conventional securing means.

In another embodiment, shown in Figure 4, first side panel 32 and second side panel 34 can comprise at least one panel support member 68 extending between and fastened to the vertical support posts 40, 42, 44, 46, 48, 50, 52 and 54. Panel support members 68 can provide additional support and stability to the modular cage 27. The first side panel 32 and the second side panel 34 can comprise any suitable material, such as metal and/or plastic. The vertical support posts 40, 42, 44, 46, 48, 50, 52 and 54 can be hollow or solid and can comprise any suitable cross-sectional shape, such as circular, square, rectangular, triangular, octagonal, and the like. Once the first side panel 32 and the second side panel 34 are assembled, at least one detachable retainer bar member 70 can be engaged between the first side panel 32 and the second side panel 34.

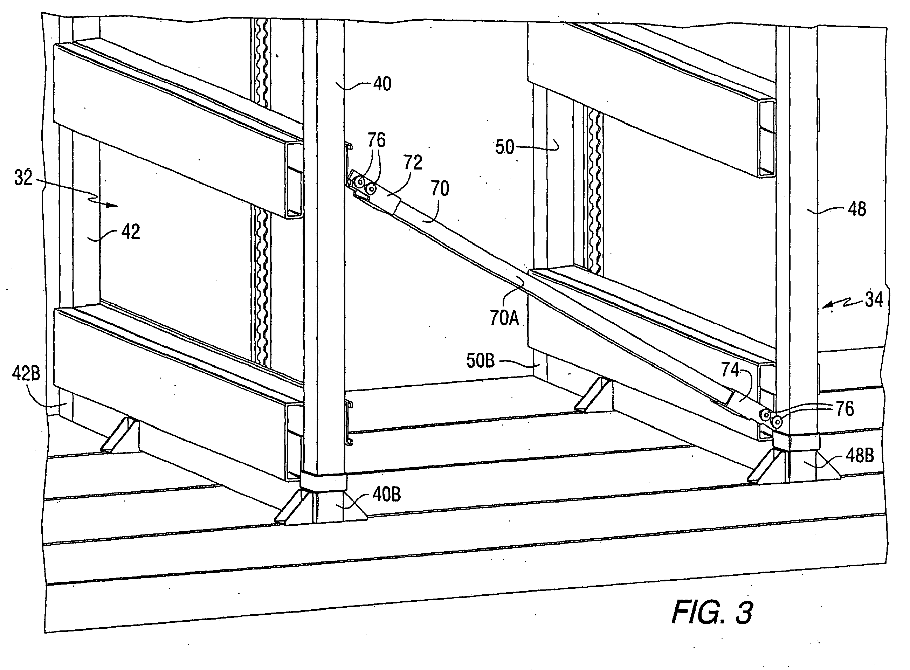

As shown in Figure 3, the retainer bar member 70 is shown in the partially engaged position between the first side panel 32 and the second side panel 34. The retainer bar member 70 comprises an elongated member section 70A, a first connection end 72 and a second connection end 74. In one embodiment, a first connection end 72 can be detachably secured to the first panel 32 along a vertical support post 40 or 42 and a second connection end 74 can be detachably secured to second side panel 34 along a vertical support post 48 or 50. It will be appreciated herein that a similar connection can be made between vertical support posts 44 and 46 and/or 52 and 54. In one embodiment, first connection end 72 and second connection end 74 can each comprise any suitable fastening means 76, such as pins, retractable pins, and the like, for detachably securing the retainer bar member 70 to the first side panel 32 and the second side panel 34. In one embodiment, a retainer bar member 70 can extend from a lower end of the front vertical support post 40B to a lower end of the front vertical support post 48B. It will be appreciated herein that a retainer bar member 70 can be similarly positioned at any location between any of the vertical support posts. For example, retainer bar member 70 can extend between an upper end, a lower end, or a position therebetween, from one vertical support post to another vertical support post such as between a lower rear end of the vertical support post 42B and a lower rear end of the vertical support post 50B.

As shown in Figure 4, a plurality of detachable retainer bar members 70 can be secured to the first side panel 32 and the second side panel 34. The retainer bar members 70 can be secured to any desired surface of the vertical support members of the first side panel 40, 42, 44 or 46, and any desired surface of the vertical support members of the second side panel 48, 50, 52 or 54.

Referring again to Figure 4, the assembled modular cage 27 can have any dimensions suitable for receiving a moveable insert rack within the interior of the modular cage 27 as will be described herein. In one embodiment, the modular cage 27 has an interior length of from about 32 to about 36 inches (about 81 to about 91 cm), an interior height of from about 78 to about 82 inches (about 198 to about 208 cm), and an interior width of from about 32 to about 36 inches (about 81 to about 91 cm). The external length of the modular cage can be from about 36 to about 40 inches (about 91 to about 101 cm), the exterior width of the modular cage can be from about 36 to about 40 inches (about 91 to about 101 cm), and the exterior height of the modular cage can be from about 82 to about 86 inches (about 208 to about 218 cm). The modular cage 27 can be constructed from any suitable materials such as lightweight plastics and/or metals capable of withstanding structural shock loads and vibrations induced by restraining the modular cage 27 in travel within a vehicle.

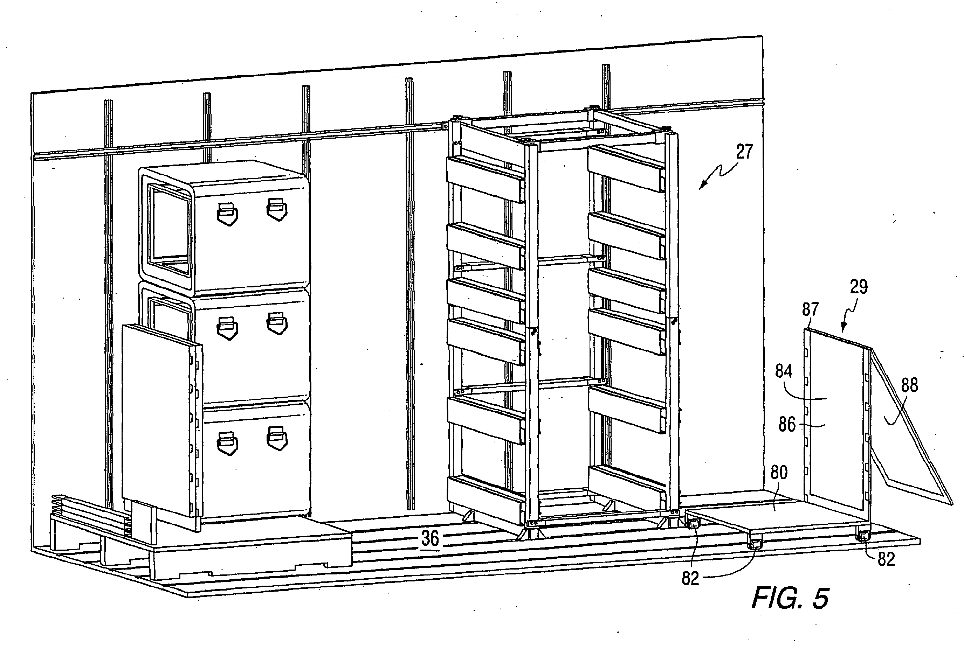

Figure 5 shows the modular cage 27 in the fully assembled position and the moveable insert rack 29 in a partially assembled position. The moveable insert rack 29 can comprise a base 80 having at least one caster 82 structured to moveably contact a surface, such as a floor 36. The base 80 can comprise any shape, such as square or rectangular. In one embodiment, the base 80 comprises a caster 82 located at each corner. In another embodiment, the base 80 has a square shape and comprises four casters 82, one caster 82 located at each corner of the base 80. A back insert panel 84 is structured to engage the base 80. The back insert panel 84 can comprise a continuous panel or can comprise a plurality of panel segments. As shown in Figure 5, the back insert panel can comprise a lower panel 86 and an upper panel 88. In one embodiment, the lower panel 86 and the upper panel 88 are hinged together along hinge 87 such that the lower panel 86 and the upper panel 88 are in substantially the same plane in an extended position and can be folded substantially adjacent each other in a collapsed position. As used herein, the term "hinge" can include any suitable hinge means, such as mechanical hinges, living hinges, and the inclusion of material(s) having a greater degree of flexibility than the material(s) comprising the lower panel and the upper panel.

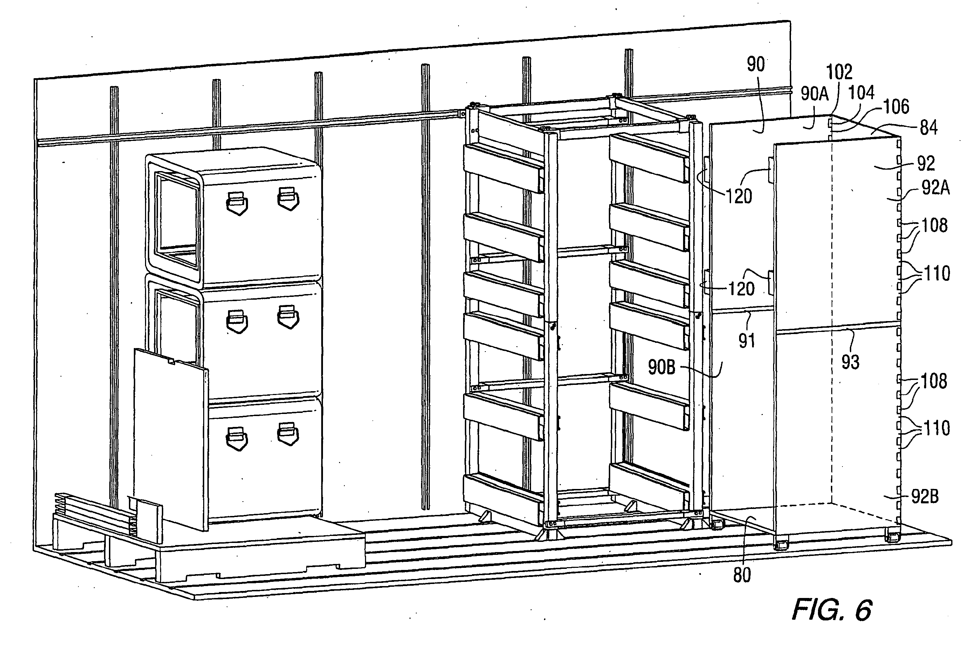

As shown in Figure 6, a first insert panel 90 and a second insert panel 92 can be configured to engage the base 80. The first insert panel 90 and the second insert panel 92 can each comprise a continuous panel or can comprise a plurality of panel segments 90A, 90B, 92A and/or 92B. As shown in Figure 6, the first insert panel 90 can comprise a lower panel 90B and an upper panel 90A. Likewise, the second insert panel 92 can comprise a lower panel 92B and an upper panel 92A. In one embodiment, the lower panel 90B and the upper panel 90A are hinged together along hinge 91 such that the lower panel 90B and the upper panel 90A are in substantially the same plane in an extended position and can be folded substantially adjacent each other in a collapsed position. In another embodiment, the lower panel 92B and the upper panel 92A are hinged together along hinge 93 such that the lower panel 92B and the upper panel 92A are in substantially the same plane in an extended position and can be folded substantially adjacent each other in a collapsed position. In one embodiment, each of the first insert panel 90A and 90B, the second insert panel 92A and 92B, and the back insert panel 84 are each removeably mounted on the pallet in a collapsed position and transitioned to an extended position during assembly within a confined space, such as a vehicle interior.

As shown in Figure 6, each of the first insert panel 90 and the second insert panel 92 can engage the base 80 by any suitable engaging means. In one embodiment, each of the lower panel 90B, the lower panel 92B and the back insert panel 84 can comprise at least one pin structured to engage a hole positioned within the base 80. In another embodiment, each of the lower panel 90B, the lower panel 92B and the back insert panel 84 can comprise at least one hole structured to engage a pin positioned within the base 80. Each of the lower panel 90B, the lower panel 92B and the back insert panel 84 can comprise a plurality of holes and/or pins positioned to engage a plurality of holes and/or pins positioned along the perimeter of the base 80. Once engaged with the base 80, the first insert panel 90, the second insert panel 92, and the back insert panel 84 can extend upwards from the base 80 in a vertical direction. As shown in Figure 6, the first insert panel 90 and the second insert panel 92 can comprise at least one handle 120 suitable to allow a user to maneuver the moveable insert rack once fully assembled as will be described herein.

As shown in Figure 6, the first insert panel 90, the second insert panel 92, and/or the back insert panel 84 can comprise at least one locking mechanism 102 for securing the first insert panel 90 to the back insert panel 84 and/or for securing the second insert panel 92 to the back insert panel 84. As shown in Figure 6, locking mechanism 102 can comprise a plurality of tabs 104 integrally connected to the first side panel 90 and a plurality of tabs 106 integrally connected to the back insert panel 84. The tabs 104 and 106 can be snapped together or coupled by a pin to hold the first side panel 90 together with the back insert panel 84. In another embodiment, the locking mechanism 102 can comprise a plurality of tabs 108 integrally connected to the second side panel 92 and a plurality of tabs 110 integrally connected to the back insert panel 84. The tabs 108 and 110 can be snapped together or coupled by a pin to hold the second side panel 92 together with the back insert panel 84.

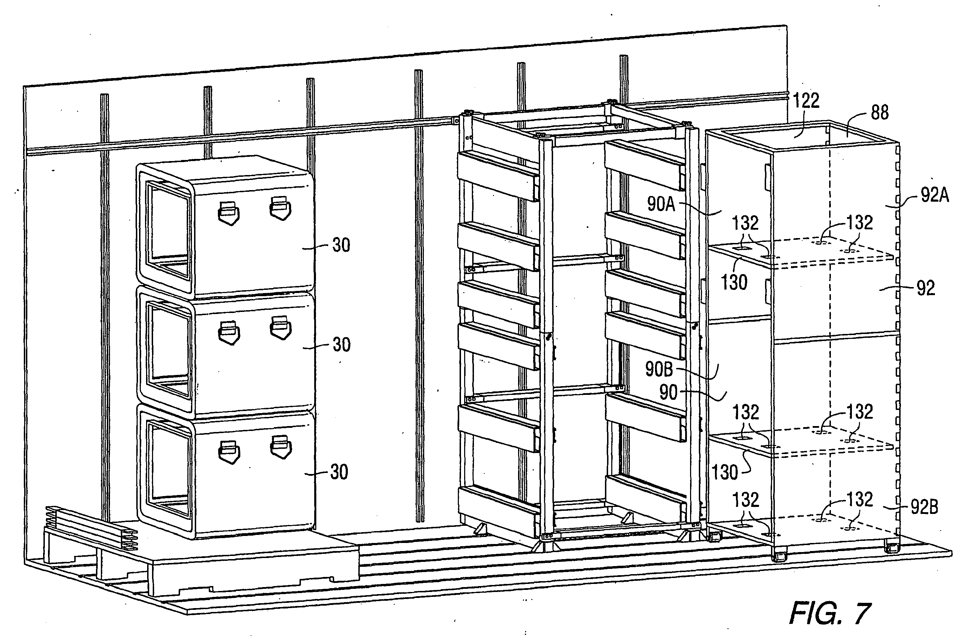

As shown in Figure 7, a top panel 122 can be attached to each of the upper panel 90A, the upper panel 92A and the upper panel 88 by any suitable engaging means. In one embodiment, each of the upper panel 90A, the upper panel 92A and the upper panel 88 can comprise at least one pin structured to engage a hole positioned within the top panel 122. In another embodiment, each of the upper panel 90A, the upper panel 92A and the upper panel 88 can comprise at least one hole structured to engage a pin positioned within the top panel 122. Each of the upper panel 90A, the upper panel 92A and the upper panel 88 can comprise a plurality of holes and/or pins positioned to engages a plurality of holes and/or pins positioned along the perimeter of the top panel 122.

As shown in Figure 7, at least one shelf 130 can be removeably mounted and extend between the first side panel 90 and the second side panel 92. The shelf 130 can have any suitable dimensions such that it can engage the interior of the first side panel 90 and the second side panel 92. In one embodiment, the shelf 130 can be positioned at multiple locations within the interior of the moveable insert rack along the first side panel 90 and the second side panel 92, such as positioned between the lower panel 90B and the lower panel 92B. Multiple shelves can be positioned within the interior of the moveable insert rack, such as vertically stacked on top of each other. In another embodiment, the shelf 130 can comprise at least one equipment holder 132 structured to assist in restraining an article and/or an article housing 30, shown in Figure 7 in the un-engaged pallet-mounted position, on the shelf 130. The equipment holder 132 can comprise a non-skid material such as rubber. The equipment holder 132 can be angled so as to provide skid resistance for an article and/or article housing 30 positioned on the shelf 130. The equipment holder 132 can also comprise a protrusion structured to engage at least a portion of a surface of an article and/or article housing 30 to resist movement once the article and/or article housing is positioned on the shelf 130.

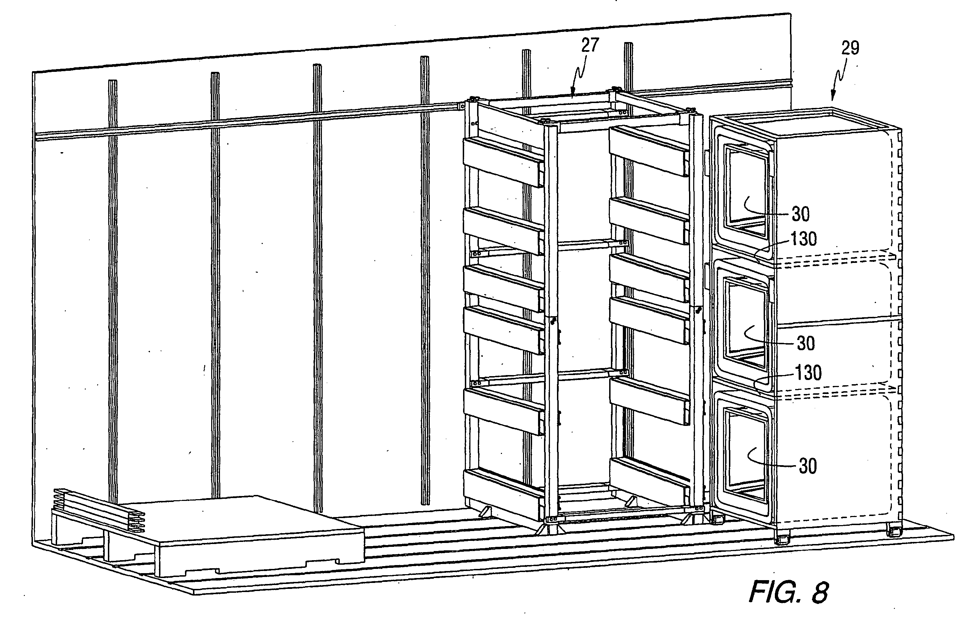

As shown in Figure 8, an article(s) and/or article housing(s) 30 can be positioned within the interior of the moveable insert rack 29 on a shelf 130. Multiple articles can be positioned within the moveable insert rack 29, such as at least one article on each shelf 130. The moveable insert rack 29 can have any suitable dimensions such that the moveable insert rack 29 can be at least partially inserted into the interior of the modular cage 27. In one embodiment, the moveable insert rack 29 has an interior length of from about 30 to about 33 inches (about 76 to about 84 cm), an interior height of from about 75 to about 79 inches (about 191 to about 201 cm), and an interior width of from about 28 to about 32 inches (about 71 to about 81 cm). The external length of the moveable insert rack 29 can be from about 30 ¾ to about 33 ¾ inches (about 78 to about 86 cm), the exterior width of the moveable insert rack 29 can be from about 28 ¾ to about 32 ¾ inches (about 73 to about 83 cm), and the exterior height of the moveable insert rack 29 can be from about 77 ¾ to about 81 ¾ inches (about 198 to about 208 cm). The moveable insert rack 29 can be constructed from any suitable materials such as lightweight plastics and/or metals capable of withstanding structural shock loads and vibrations induced by restraining the moveable insert rack 29 in travel within a vehicle.

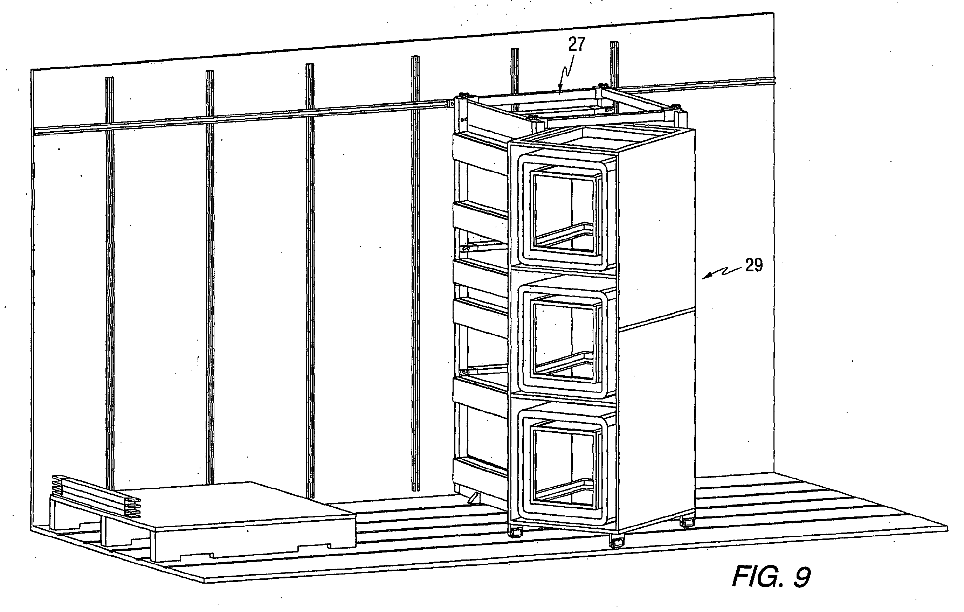

As shown in Figures 9-10 and 12, the moveable insert rack 29 can be inserted at least partially within the interior of the modular cage 27.

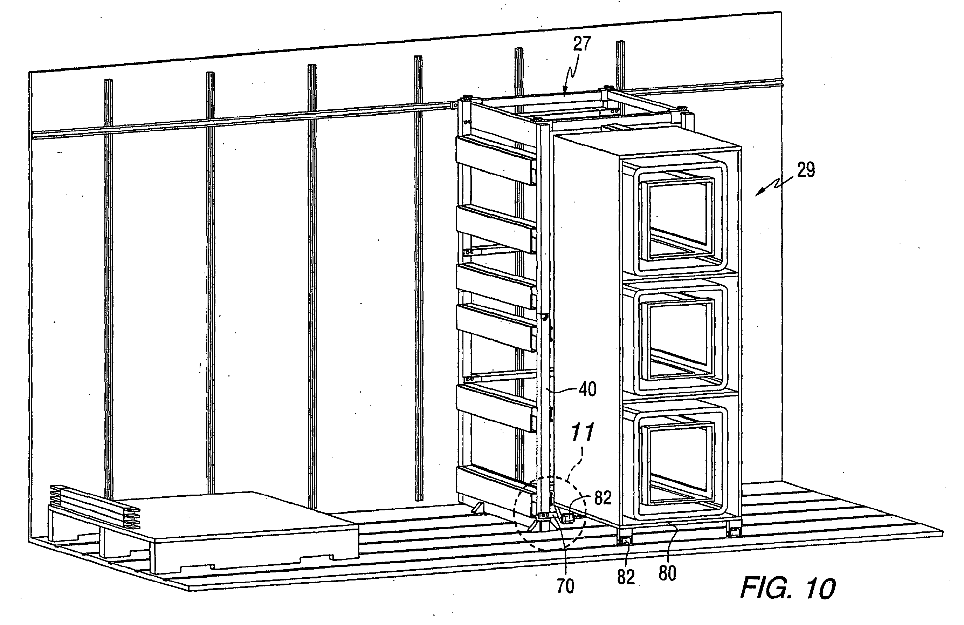

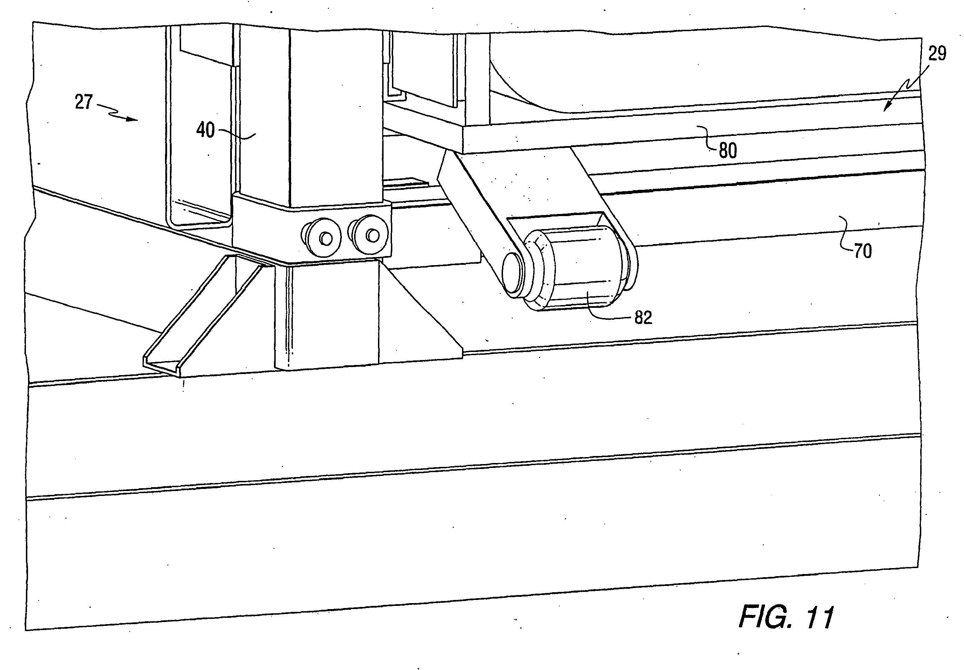

As shown in Figures 10 and 11, the casters 82 can be at least partially retractable towards the base 80. In one embodiment, the casters 82 are retractable towards the base 80such that the moveable insert rack 29 can be inserted within the interior of the modular cage 27 over a retainer bar member 70 positioned between a lower end of the front vertical support post 40 and a lower end of the front vertical support post 48 (not shown). As the moveable insert rack 29 is inserted into the interior of the modular cage 27, the casters 82 can retract toward the base 80 to a degree sufficient to allow the moveable insert rack to maintain substantially the same vertical height as the caster 82 is retracted. In one embodiment, two casters 82 positioned at the rear of the moveable insert rack 29 are retracted (for example, pivoted) over a retainer bar member 70 positioned between a lower end of the front vertical support post 40 and a lower end of the front vertical support post 48 followed by two casters 82 positioned at the front of the moveable insert rack 29.

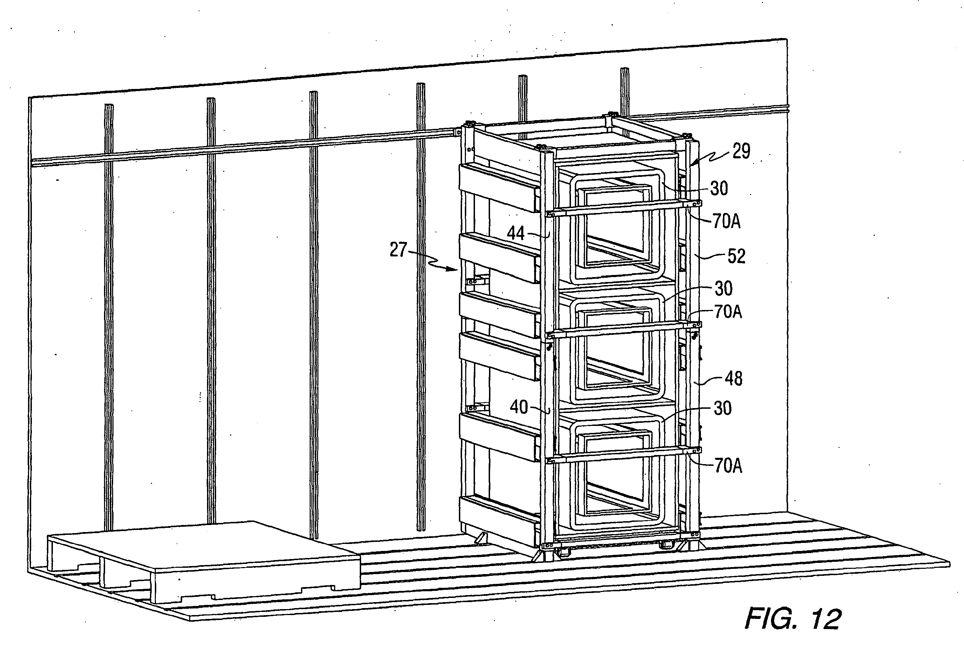

As shown in Figure 12, once the moveable insert rack 29 is inserted into the interior of the modular cage 27, at least one retainer bar member 70A can be positioned between the lower front vertical support post 40 and the lower front vertical support post 48 and/or the upper front vertical support post 44 and the upper front vertical support post 52. In one embodiment, the retainer bar member 70A can extend between the lower front vertical support post 40 and the lower front vertical support post 48 and/or the upper front vertical support post 44 and the upper front vertical support post 52 at a location such that at least a portion of an article and/or article housing 30 is restrained by the retainer bar member 70A.

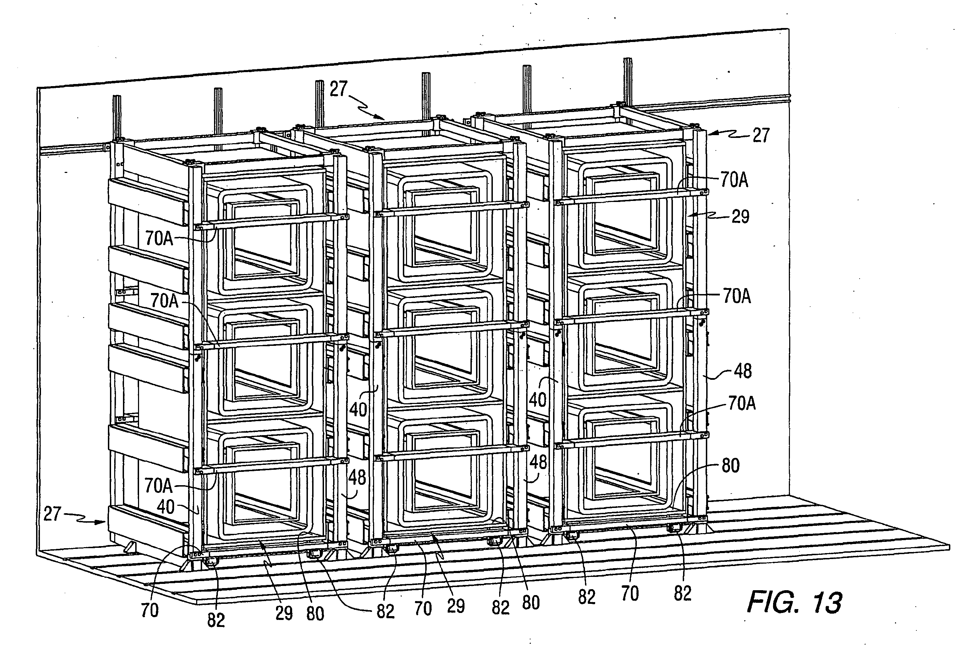

As shown in Figure 13, multiple modular cages 27 and multiple moveable insert racks 29 can be positioned adjacent each other. In one embodiment, multiple modular cages 27 can be joined together to form a modular cage network and/or fastened to a surface such as a floor, ceiling or wall. In one embodiment, a moveable insert rack can be removed from a modular cage by removing the retainer bars 70A and sliding the moveable insert rack out from the interior of the modular cage. The casters 82 can be retracted (for example, pivoted) toward the base 80 to allow the moveable insert rack to pass over the retainer bar 70 positioned between a lower end of the front vertical support post 40 and a lower end of the front vertical support post 48. Once the moveable insert rack 29 is removed from the interior of the first modular cage 27, it can be inserted within the interior of another modular cage in the modular cage network by the process described herein. The ability to remove a moveable insert rack 29 from one location within a modular cage network and insert the moveable insert rack 29 into another location within the modular cage network allows a user to customize the location of articles and/or article housings 30 in response to varying or changing working conditions.

Whereas particular embodiments of this invention have been described above for purposes of illustration, it will be evident to those skilled in the art that numerous variations of the details of the present invention may be made without departing from the invention as defined in the appended claims.

## Claims

1. A transportable modular rack system (20) comprising:
a modular cage (26) securable to a surface comprising:
a first side panel (32),
a second side panel (34) opposite the first side panel (32), and
at least one detachable retainer bar member (70) extending from the first side panel (32) to the second side panel (34); and
a moveable insert rack (28) at least partially receivable within the modular cage (26), the moveable insert rack comprising:
a base (80),
a first and second insert panel (90,92) detachably mounted on the base (80), and
at least one shelf (130) removeably mounted on and extending between the first and second insert panels (90,92).

2. A transportable modular rack system (20) according to claim 1, wherein the first side panel (32) and the second side panel (34) each comprise two vertical support members (40,42,48,50).

3. A transportable modular rack system (20) according to claim 1 or claim 2, wherein the first side panel (32) and the second side panel (34) each comprise at least two detachable sections (32A,32B,34A,34B).

4. A transportable modular rack system (20) according to any preceding claim, further comprising a plurality of detachable retainer bar members (70A) extending between the first side panel (32) and the second side panel (34).

5. A transportable modular rack system (20) according to any preceding claim, wherein the base (80) comprises at least one caster (82).

6. A transportable modular rack system (20) according to claim 5, wherein the caster (82) is at least partially retractable toward the base (80) to allow the caster (82) to pass over the retainer bar member (70) when the moveable insert rack (28) is at least partially installed within the modular cage (26).

7. A transportable modular rack system (20) according to any preceding claim, wherein the moveable insert rack (28) further comprises a back insert panel (84) detachably mounted on the base (80) and connected to each of the first insert panel (90) and the second insert panel (92).

8. A transportable modular rack system (20) according to claim 7, wherein the back insert panel (84) has a top end and a bottom end and is hinged (87) at a location between the top end and the bottom end.

9. A transportable modular rack system (20) according to any preceding claim, wherein each of the first and second insert panels (90,92) have a top and a bottom end and are hinged (91,93) at a location between the top end and the bottom end.

10. A transportable modular rack system (20) according to any preceding claim, wherein the at least one shelf (130) is vertically adjustable along the first insert panel (90) and second insert panel (92).

11. A transportable modular rack system (20) according to any preceding claim, wherein the at least one shelf (130) is structured and arranged to receive at least one article and/or article housing (30).

12. A transportable modular rack system (20) according to any preceding claim, wherein the detachable retainer bar member (70) extends between a lower end of a front vertical support post (40) of the first side panel (32) and a lower end of a front vertical support post (48) of the second side panel (34).

13. A transportable modular rack system (20) according to any preceding claim, wherein the surface is a floor (36), wall (38) and/or ceiling.

14. A method of assembling a modular rack in a vehicle (22) comprising the steps of:
securing a modular cage (26) comprising a retainer bar (70) to the vehicle (22);
assembling a moveable insert rack (28); and
inserting the moveable insert rack (28) at least partially within the modular cage (26) by sliding the moveable insert rack (28) over the retainer bar (70) at least partially into the modular cage (26).

15. A method according to claim 14, further comprising the step of installing at least one other retainer bar (70A) on the modular cage (26) after the moveable insert rack (28) is at least partially inserted into the modular cage (26).

16. A transportable pallet-mounted modular rack system (20) comprising:
modular cage components (26) removeably mounted on a pallet, the modular cage components comprising:
first and second side panels (32,34), and
at least one detachable retainer bar member (70) which may be secured between the first and the second side panels (32,34); and
moveable insert rack components (28) removeably mounted on the pallet, the moveable insert rack components comprising:
a base (80),
first and second insert panels (90,92) detachably mountable on the base (80), and
at least one shelf (130) which may be removeably mountable on and extendable between the first and second insert panels (90,92).

17. A transportable pallet-mounted system (20) according to claim 16, further comprising at least one article and/or article housing (30) positioned on the pallet.
